(19) Europäisches Patentamt
European Patent Office
Office européen des brevets

(11) **EP 1 430 575 B1**

(12) **EUROPÄISCHE PATENTSCHRIFT**

(45) Veröffentlichungstag und Bekanntmachung des Hinweises auf die Patenterteilung:
**25.11.2009 Patentblatt 2009/48**

(51) Int Cl.:
**H01S 5/00** (2006.01)

(21) Anmeldenummer: 02776735.9

(22) Anmeldetag: **26.09.2002**

(86) Internationale Anmeldenummer:
**PCT/DE2002/003651**

(87) Internationale Veröffentlichungsnummer:
**WO 2003/030316 (10.04.2003 Gazette 2003/15)**

(54) **OPTISCH GEPUMPTER VERTIKAL EMITTIERENDER HALBLEITERLASER**

OPTICALLY PUMPED, VERTICALLY EMITTING SEMICONDUCTOR LASER

LASER A SEMI-CONDUCTEUR A EMISSION VERTICALE, UTILISANT LE POMPAGE OPTIQUE

(84) Benannte Vertragsstaaten:
**DE**

(30) Priorität: **28.09.2001 DE 10147888**

(43) Veröffentlichungstag der Anmeldung:
**23.06.2004 Patentblatt 2004/26**

(73) Patentinhaber: **OSRAM Opto Semiconductors GmbH**
**93055 Regensburg (DE)**

(72) Erfinder: **SCHMID, Wolfgang**
**93180 Deuerling (DE)**

(74) Vertreter: **Epping - Hermann - Fischer Patentanwaltsgesellschaft mbH**
**Ridlerstrasse 55**
**80339 München (DE)**

(56) Entgegenhaltungen:
**EP-A- 0 653 823      EP-A- 0 748 007**
**EP-A- 0 860 915      US-A1- 2002 090 016**
**US-B1- 6 285 702**

- **ORTSIEFER M ET AL: "LOW-THRESHOLD INDEX-GUIDED 1.5 MUM LONG-WAVELENGHT VERTICAL-CAVITY SURFACE-EMITTING LASER WITH HIGH EFFICIENCY" APPLIED PHYSICS LETTERS, AMERICAN INSTITUTE OF PHYSICS. NEW YORK, US, Bd. 76, Nr. 16, 17. April 2000 (2000-04-17), Seiten 2179-2181, XP000950426 ISSN: 0003-6951**
- **GRABHERR M ET AL: "BOTTOM-EMITTING VCSEL'S FOR HIGH-CW OPTICAL OUTPUT POWER" IEEE PHOTONICS TECHNOLOGY LETTERS, IEEE INC. NEW YORK, US, Bd. 10, Nr. 8, 1. August 1998 (1998-08-01), Seiten 1061-1063, XP000769856 ISSN: 1041-1135**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen optisch gepumpten vertikal emittierenden Halbleiterlaser mit einer hochreflektierenden Reflektorschicht, einer auf der Reflektorschicht angeordneten, strahlungsemittierenden aktiven Schichtenfolge, bei dem im Betrieb die Reflektorschicht zusammen mit einem externen Spiegel einen Laserresonator bildet.

In der Veröffentlichung Ortsiefer et al., "Low-threshold index-guided 1.5$\mu$m long-wavelength vertical cavity surface emitting laser with high efficiency", Appl. Phys. Lett., vol. 76, no. 16, pp 2179 bis 2181 vom 17. April 2000, ist ein elektrisch gepumpter Laser mit internem Resonator (VCSEL) beschrieben.

Optisch gepumpte Halbleiterlaser sind beispielsweise aus dem Artikel M. Kuznetsov et al., "Design and Characteristics of High-Power (>0.5 W CW) Diode-Pumped Vertical-External-Cavity Surface-Emitting Semiconductor Lasers with Circular TEM00 Beams", IEEE J. Selected Topics Quantum Electron., vol. 5, no. 3, pp 561-573, 1999, bekannt. Ein optisch gepumpter Laser mit externem Resonator ist ebenfalls in der US 6,285,702 B1 beschrieben.

Diese VECSELs ermöglichen eine hohe Dauerstrich-Strahlungsleistung bis in den Watt-Bereich bei guter Strahlqualität. Allerdings stellt sich beim Hochleistungsdauerstrichbetrieb das Problem, die beispielsweise durch nichtstrahlende Rekombinationen erzeugte Verlustwärme effizient aus dem Bauelement abzuführen.

Zu diesem Zweck wird der von Kuznetsov et al. beschriebene optisch gepumpte VECSEL auf eine Diamant-Wärmesenke mit hoher thermischer Leitfähigkeit montiert. Da das Wachstumssubstrat wesentlich zur thermischen Impedanz des Bauelements beiträgt, wird es bevorzugt entfernt und der VECSEL direkt mit den Spiegelschichten auf die Wärmesenke aufgebracht.

Diese Vorgehensweise erzwingt allerdings eine Upside-down Montage des Bauelements. Zusätzlich besteht beim Entfernen des Wachstumssubstrats die Gefahr eines Bruchs des Bauelements.

Hier setzt die Erfindung an. Der Erfindung, wie sie in den Ansprüchen gekennzeichnet ist, liegt die Aufgabe zugrunde, einen gattungsgemäßen vertikal emittierenden Halbleiterlaser anzugeben, der die Nachteile des Stands der Technik vermeidet und der insbesondere auch bei hohen Dauerstrichleistungen zuverlässig betrieben werden kann.

Diese Aufgabe wird erfindungsgemäß durch den vertikal emittierenden Halbleiterlaser nach Anspruch 1 gelöst. Bevorzugte Ausgestaltungen ergeben sich aus den Unteransprüchen.

Erfindungsgemäß ist bei einem vertikal emittierender Halbleiterlaser der eingangs genannten Art innerhalb des Laserresonators und in thermischen Kontakt mit der aktiven Schichtenfolge eine für die emittierte Strahlung transparente Wärmesenke angeordnet, die aus einem Material gebildet ist, das eine höhere Wärmeleitfähigkeit als die Materialien der aktiven Schichtenfolge aufweist.

Die Erfindung basiert auf der Beobachtung, daß die Reflektorschicht, die üblicherweise durch einen verteilten Braggreflektor, also einer alternierenden Folge hoch- und niedrigbrechender Schichten einer Dicke von $\lambda$/4n gebildet ist, ein wesentliches Hindernis für den Wärmeabfluß darstellt. Davon ausgehend beruht die Erfindung auf dem Gedanken, für die Wärmeabfuhr die Reflektorschicht zu umgehen oder durch eine Wärmespreizung die Fläche zu erhöhen, über die die Reflektorschicht die Wärme abführen muß.

Erreicht wird dieses Ziel durch eine innerhalb der Resonators angeordnete Wärmesenke, die in Wärmekontakt mit der aktiven Schichtenfolge steht, deren Wärmeleitfähigkeit höher ist als die Materialien der aktiven Schicht.

Dabei kann durch die Gestaltung der Wärmesenke und der Reflektorschicht erreicht werden, daß der abgeführte Wärmestrom die Reflektorschicht praktisch vollständig umgeht.

Alternativ ist es möglich, die Wärmesenke so auszugestalten, daß der abgeführte Wärmestrom gespreizt wird und die Reflektorschicht auf einer größeren Fläche durchfließt. Da der Wärmewiderstand umgekehrt proportional zur Querschnittsfläche des Wärmestroms ist, wird eine Reduktion des Wärmewiderstands erreicht.

Bevorzugt ist die Wärmesenke aus gut wärmeleitenden, im Roten und/oder Nahen Infrarot transparenten Materialien wie SiC, BN oder Diamant gebildet.

In einer vorteilhaften Ausgestaltung ist die Wärmesenke durch eine Schicht einer Dicke von mindestens dem 0,2-fachen des Durchmessers der aktiven Zone gebildet. Sie kann beispielsweise eine Dicke zwischen 3 und 50 $\mu$m, bevorzugt zwischen 5 und 30 $\mu$m, besonders bevorzugt zwischen 10 und 20 $\mu$m aufweisen.

Zweckmäßig ist die Wärmesenke zwischen der aktiven Schichtenfolge und der Reflektorschicht angeordnet. Der Wärmestrom wird dann zwischen der aktiven Schichtenfolge und der Reflektorschicht durch die Wärmesenke aufgeweitet, der Wärmewiderstand der Reflektorschicht somit reduziert.

Die Wärmesenke kann dabei in direktem Kontakt mit der aktiven Schichtenfolge stehen, oder es kann zwischen der Wärmesenke und der aktiven Schichtenfolge ein teilreflektierender Braggreflektor angeordnet sein. Letzteres ist insbesondere dann zweckmäßig, wenn die Reflektivität der Reflektorschicht hinter der Wärmesenke allein ungenügend ist, die Reflektorschicht beispielsweise aus Gold besteht.

In bevorzugten Ausgestaltungen ist die Reflektorschicht durch einen verteilten Braggreflektor gebildet, der alternierend hoch- und niedrigbrechende Schichten einer Dicke von im wesentlichen $\lambda$/4n enthält. $\lambda$ bezeichnet dabei die Wellenlänge der von der aktiven Zone emittierten Strahlung und n die Brechzahl der entsprechenden Schicht.

Die Einzelreflexionen an den Schichten überlagern sich dann konstruktiv, so daß eine hohe Gesamtreflektivität größer 99%, bevorzugt größer 99,5%, besonders bevorzugt größer 99,9% erreicht wird. Die Reflektivität R eines Braggspiegels aus m Schichtpaaren mit Brechzahlen n1 beziehungsweise n2 ist gegeben durch

$$R = \frac{1-(n1/n2)^m}{1+(n1/n2)^m}.$$

Für eine hohe Reflektivität ist also ein großer Indexkontrast n1/n2, und eine ausreichende Anzahl an Schichtpaaren erforderlich. Auch muß für die Gültigkeit der genannten Formel die Schichtdicke hinreichend genau getroffen werden.

Der Braggspiegel kann im Rahmen der Erfindung sowohl epitaktisch gewachsen werden oder es werden dielektrische Schichten abgeschieden. Während letztgenanntes Verfahren hohe Indexkontraste liefert, sind die erforderlichen Dicken nur schwer genau zu treffen. Auch besitzen Dielektrika nur eine geringe Wärmeleitfähigkeit.

Bei Verwendung epitaktischer Halbleiterschichten können die geforderte Dicken sehr genau eingehalten werden und die Wärmeleitfähigkeit ist etwas höher als die der Dielektrika. Andererseits ist erforderlich, daß die Materialien bei der Emissionswellenlänge nicht absorbieren und daß die Gitterkonstante muß für alle Schichten gleich ist. Andere Gitterkonstanten erzeugen Kristallfehler, die neben einem schlechteren Spiegel das Wachstum einer aktiven Schichtenfolge von hoher Qualität verhindern. Somit ist man bei der Verwendung epitaktischer Halbleiterschichten auf wenige Materialien beschränkt.

Im Infraroten kann beispielsweise das AlGaAs-Materialsystem, das gitterangepaßt auf GaAs-Substraten gewachsen wird, verwendet werden: im Infraroten sind die Brechungsindizes etwa 3.0 (AlAs) und 3.5 (GaAs), die Gitterkonstante ist nahezu unabhängig vom Aluminiumgehalt.

Für rot emittierende VECSEL kann der Braggspiegel ebenfalls aus dem AlGaAs-System bestehen. Wegen der kürzeren Wellenlänge absorbiert aber GaAs und muß deshalb durch AlGaAs mit mindestens 60% Aluminium ersetzt werden. Der Mischhalbleiter besitzt wiederum eine schlechtere Wärmeleitfähigkeit als die Binärhalbleiter AlAs und GaAs. Zudem verringert sich der Indexkontrast, was durch eine höhere Spiegelpaaranzahl ausgeglichen werden muß.

Die Wärmeleitfähigkeit des Braggspiegels hat sich als sehr kritisch herausgestellt: zwar besitzen beispielsweise GaAs und AlAs Wärmeleitfähigkeiten von 46 und 91 W/(m K). Zwei aufeinanderfolgende dünne Schichten aus unterschiedlichen Materialien haben aber schlechtere Wärmeleitfähigkeit, da wegen der Änderung des Kristalls die Gitterschwingungen (Phononen) nicht übereinstimmen. Die Gitterschwingungen werden daher an diesen Grenzflächen teilweise reflektiert, der gesamte Wärmewiderstand wegen diese Wärmeübergangswiderstands also vergrößert.

Ein realer Braggspiegel besteht dabei typischerweise aus 30 oder 40 Schichtpaaren, also 60 beziehungsweise 80 Grenzflächen, die jeweils zum Wärmewiderstand beitragen.

Die Wärmesenke oder eine weitere Wärmesenke kann auch auf der der Reflektorschicht abgewandten Seite der aktiven Schichtenfolge angeordnet sein, so daß die Wärme überwiegend nicht direkt über die Reflektorschicht, sondern in die Wärmesenke geleitet wird.

Letztlich kann die Wärme natürlich von der Wärmesenke wieder über die Reflektorschicht fließen, allerdings dann wegen der Wärmespreizung auf einer wesentlich größeren Fläche und damit einem geringeren Widerstand.

Alternativ können Wärmesenke und Reflektorschicht so angeordnet sein, daß die Wärme außerhalb der Reflektorschicht von der Wärmesenke in ein Substrat oder ein sonstiges größeres Wärmereservoir abfließt.

Dies kann beispielsweise dadurch geschehen, daß der Braggspiegel nur in einem zentralen Bereich des Bauelements ausgebildet ist, so daß die Wärme in einem äußeren Bereich abgeführt werden kann, ohne den Braggspiegel durchfließen zu müssen.

In einer anderen Ausgestaltung weist der optisch gepumpte vertikal emittierender Halbleiterlasers eine strahlungsemittierende aktive Schichtenfolge und zwei externen Spiegeln auf, die einen Vertikalresonator bilden. Innerhalb des Vertikalresonators und in thermischen Kontakt mit der aktiven Schichtenfolge ist eine für die emittierte Strahlung transparente Wärmesenke angeordnet, die aus einem Material gebildet ist, das eine höhere Wärmeleitfähigkeit als die Materialien der aktiven Schichtenfolge aufweist.

Besonders bevorzugt wird die erfindungsgemäße Anordnung bei optisch gepumpten vertikal emittierenden Halbleiterlasern eingesetzt, bei denen die Pumpquelle seitlich vom optisch gepumpten vertikal emittierenden Halbleiterlaser angeordnet und zusammen mit diesem auf einem gemeinsamen Substrat monolithisch integriert ist. Die Pumpquelle weist hierbei vorzugsweise eine kantenemittierende Laserstruktur oder eine Mehrzahl von kantenemittierenden Laserstrukturen auf, die mittels Epitaxie vor oder nach dem epitaktischen Herstellen der Struktur des optisch pumpbaren vertikal emittierenden Halbleiterlaser auf das gemeinsame Substrat aufgewachsen wird. Solche Laseranordnungen sind aus der DE 100 26 734 bekannt und werden von daher an dieser Stelle nicht näher erläutert.

Bei allen genannten Ausführungsformen kann die strahlungsemittierende aktive Schichtenfolge aus einem auf GaAs oder InP basierenden Halbleitermaterial bestehen, insbesondere aus InGaAs, AlGaAs, InGaAlAs, InGaP, InGaAsP, InGaAlP, InAlP oder einer Abfolge von Schichten aus einem oder mehreren diesen Materialien.

Weitere vorteilhafte Ausgestaltungen, Merkmale und Details der Erfindung ergeben sich aus den abhängigen Ansprüchen, der Beschreibung der Ausführungsbeispiele und den Zeichnungen.

Nachfolgend wird die Erfindung anhand von Ausführungsbeispielen in Verbindung mit den Zeichnungen näher erläutert. In den Zeichnungen sind jeweils nur die für das Verständnis der Erfindung wesentlichen Elemente dargestellt. Dabei zeigen:

Figuren 1-6   schematische Schnittdarstellungen verschiedener Ausführungsformen der Erfindung;

Figur 7   eine schematische Schnittdarstellung der Schichten- abfolge des Halbleiterlasers von Fig. 2, und

Figur 8   eine schematische Schnittdarstellung eines weiteren Ausführungsbeispiels.

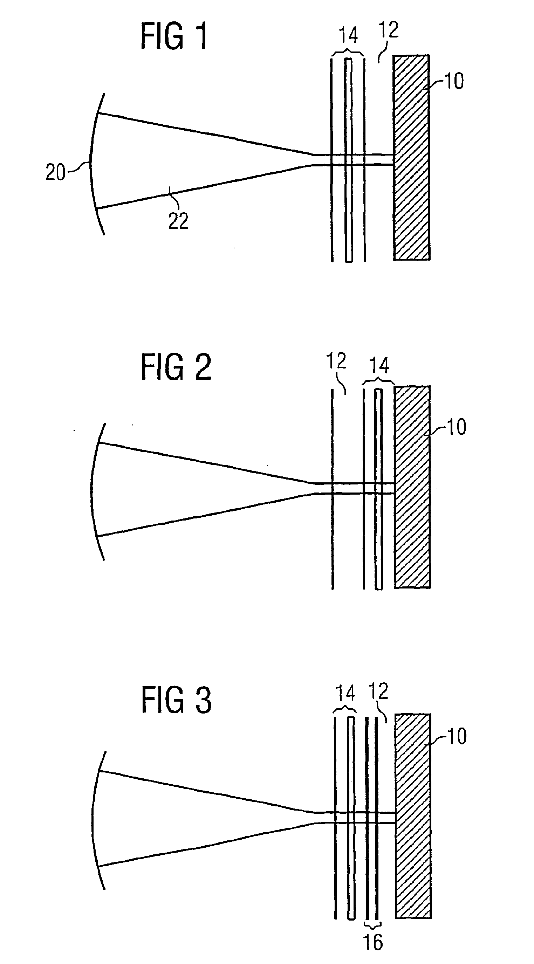

Figur 1 zeigt eine Ausführungsform eines erfindungsgemäßen optisch gepumpten vertikal emittierender Halbleiterlasers (VECSEL) in schematischer Darstellung. Zwischen dem Braggspiegel 10 und der aktiven Schichtenfolge 14 ist eine Wärmesenke 12 angeordnet, etwa eine 10 $\mu$m dicke SiC-Schicht.

Der Laserresonator ist durch den Braggspiegel 10 und den externen Hohlspiegel 20 gebildet, über den auch ein Teil der im Resonator umlaufenden Strahlung 22 ausgekoppelt wird.

Der VECSEL wird in an sich bekannter Weise optisch gepumpt, beispielsweise ein bei 950 nm emittierender VECSEL durch Fokussierung des Multimodenstrahls einer 808 nm - Standard-Hochleistungs-Pumpdiode.

Die Pumpleistung wird im aktiven Medium absorbiert, wodurch neben der gewollten Laseremission auch Wärme, insbesondere durch nichtstrahlende Rekombination angeregter Ladungsträger entsteht. Diese Wärme muß über den Braggspiegel 10 in ein angrenzendes Substrat oder ein anderes Wärmereservoir abfließen.

Die Querschnittsfläche des Wärmestroms wird durch die Wärmesenke 12 gegenüber der Querschnittsfläche der Laserstrahlung 22 durch laterale Wärmediffusion stark vergrößert. Der Wärmestrom fließt daher auf größerer Fläche durch die Braggspiegel 10, wodurch der Wärmewiderstand entsprechend reduziert wird.

Eine andere Ausführungsform ist in Figur 2 gezeigt. Dort ist die Wärmesenke 12 auf der dem Braggspiegel 10 abgewandten Seite der aktiven Schichtenfolge 14 angeordnet. Die in der aktiven Schichtenfolge 14 erzeugte Wärme fließt dabei in die Wärmesenke 12, breitet sich dort durch laterale Wärmediffusion über eine große Fläche aus, bevor sie letztlich über den Braggspiegel 10 in das (nicht gezeigte) Substrat abfließt. Dabei kann durch Strukturierung des Braggspiegels auch erreicht werden, daß ein großer Teil der Wärme unter Umgehung des Spiegels in das Substrat fließt.

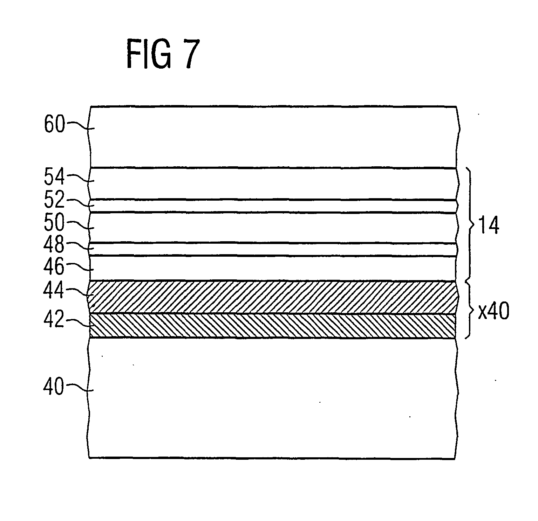

Ein mögliche Schichtabfolge für die Ausführungsform der Fig. 2 ist in Fig. 7 dargestellt. Auf einem GaAs-Substrat 40 ist ein Braggspiegel, bestehend aus 40 Schichtpaaren aus AlAs (Bezugzeichen 42) und AlGaAs (Bezugzeichen 44) mit mindestens 60% Aluminiumanteil epitaktisch aufgewachsen. Jede der Schichten 42, 44 hat eine Dicke von $\lambda/4n$, bei einer Emissionswellenlänge von $\lambda = 650$ nm also eine Dicke von etwa 50 nm.

Auf dem Braggspiegel ist die aktive Schichtenfolge 14 aufgewachsen, die aus zwei etwa 5 nm breiten InGaP-Quantentöpfen 48, 52 und InAlP-Barrieren 46, 50, 54 einer Dicke von $\lambda/4n$ besteht. Die Zahl der Quantentöpfe kann dabei auch größer sein, beispielsweise 6 oder 10. Auf die aktiven Schichtenfolge 14 ist zur lateralen Wärmespreizung eine 10 $\mu$m dicke SiC-Schicht als Wärmesenke aufgebracht.

Bei der Ausführungsform nach Fig. 3 ist der Spiegel 10 durch eine Goldschicht gebildet. Die geringere Reflektivität eines solchen Spiegels kann durch einen zwischen aktiver Schichtenfolge 14 und Wärmesenke 12 angeordneten Braggspiegel 16 reduzierter Periodizität ausgeglichen werden. Wegen der kleineren Anzahl an Schichtenfolgen ist auch der Wärmewiderstand dieses Braggspiegels 16 geringer, so daß insgesamt eine im Vergleich zu herkömmlichen Gestaltungen bessere Wärmeabfuhr erreicht wird.

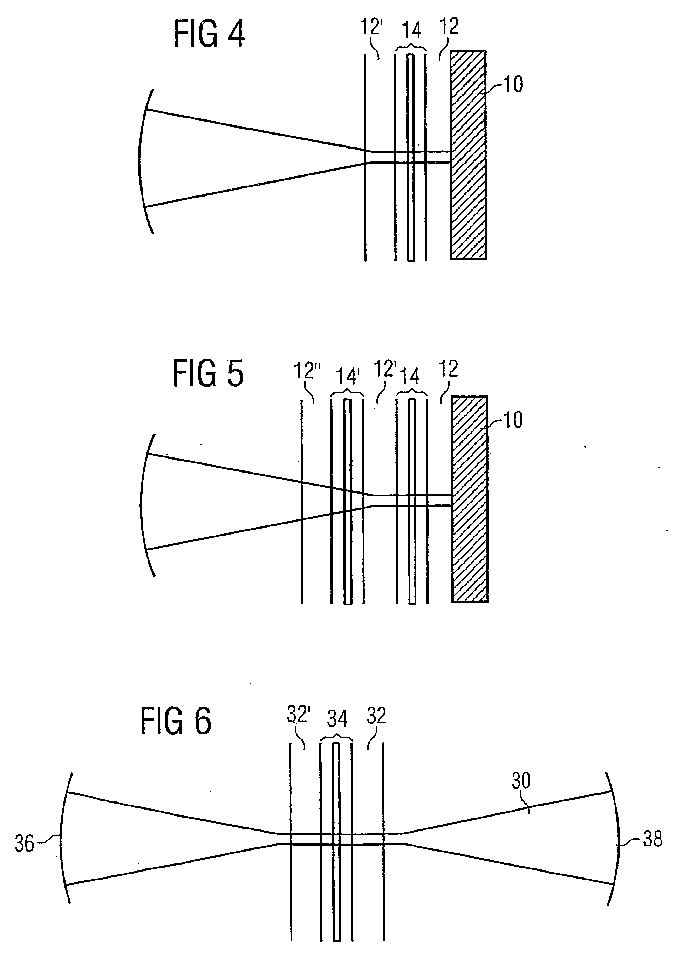

Figur 4 zeigt eine weitere Ausführungsform eines VECSELS, bei der beiderseits der aktiven Schichtenfolge 14 Wärmesenken 12 und 12' angeordnet sind. Die im Zusammenhang mit Figuren 1 und 2 beschriebenen Vorteile werden dadurch kombiniert.

Es ist weiterhin möglich, mehrere Abfolgen aus aktiver Schichtenfolge und Wärmesenke hintereinander anzuordnen, wie im Fig. 5 gezeigt. Dort grenzen zwei aktive Schichtenfolgen 14, 14' jeweils an beiden Seiten an Wärmesenken 12, 12', beziehungsweise 12', 12 " an.

Ein andere optisch gepumpter vertikal emittierender Halbleiterlaser ist in Fig. 6 dargestellt. Der interne Spiegel ist bei dieser Gestaltung durch einen zweiten externen Spiegel ersetzt, so daß ein Vertikalresonator durch zwei externe Hohlspiegel 36, 38 gebildet ist, in dem die Laserstrahlung 30 umläuft.

Die aktive Schichtenfolge 34 ist zwischen zwei Wärmesenken 32, 32', im Ausführungsbeispiel jeweils 15 $\mu$m dicke BN-Schichten, angeordnet.

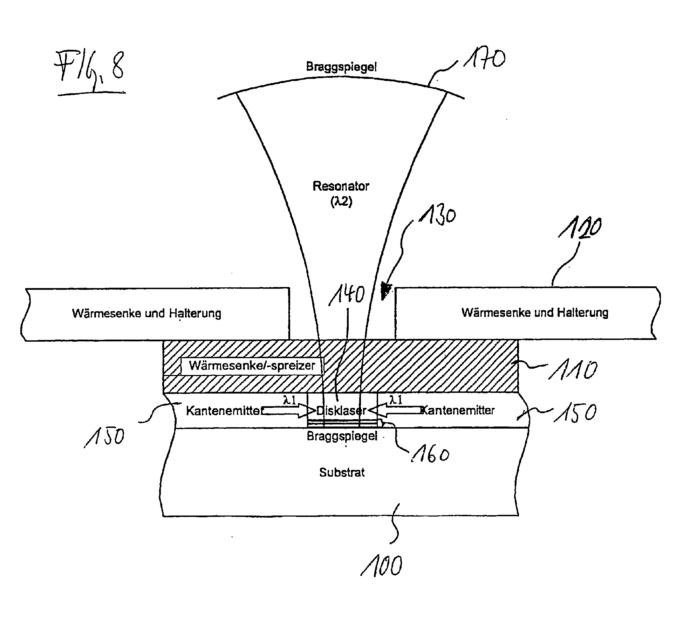

Bei dem in Figur 8 dargestellten Ausführungsbeispiel ist eine optisch pumpbare vertikal emittierende Halbleiterlaserstruktur 140 zusammen mit einer kantenemittierenden Laserstruktur 150 auf einem gemeinsamen Substrat 100 monolithisch integriert. Die kantenemittierend Laserstruktur 150 stellt die Pumpquelle für die optisch pumpbare vertikal emittierende Halbleiterlaserstruktur 140 dar. Die optisch pumpbare vertikal emittierende Halbleiterlaserstruktur 140 und die kantenemittierende Laserstruktur 150 sind mittels Epitaxie auf dem Substrat 100 aufgebracht, wobei die kantenemittierende Laserstruktur 150 vor oder nach dem epitaktischen Herstellen der Struktur des optisch pumpbaren vertikal emittierenden Halbleiterlaser 140 auf das gemeinsame Substrat 100 aufgewachsen sein kann. Auf den Laserstrukturen befindet sich eine wärmeleitende Schicht 110, die als Wärmesenke oder Wärmespreizer dient, auf der sich wiederum eine Wärmesenke 120 mit einem über der optisch pumpbaren vertikal emittierenden Halbleiterlaserstruktur 140 angeordneten Strahlungsfenster 130 befindet. Zwischen der optisch pumpbaren vertikal emittierenden Halbleiterlaserstruktur 140 und dem Substrat 100 befindet sich ein Braggspiegel 160, der zusammen mit einem von der optisch pumpbaren vertikal emittierenden Halbleiterlaserstruktur 140 aus gesehen dem Strahlungsfenster 130 nachgeordneten Braggspiegel 170 den Laserresonator für die optisch pumpbare vertikal emittierende Halbleiterlaserstruktur 140 bildet.

## Patentansprüche

1. Optisch gepumpter vertikal emittierender Halbleiterlaser mit einer strahlungsemittierenden aktiven Schichtenfolge (14,34), wobei
entweder
der Halbleiterlaser eine hochreflektierende Reflektorschicht (10) aufweist, auf der die strahlungsemittierende aktive Schichtenfolge (14) angeordnet ist und die Reflektorschicht (10) im Betrieb zusammen mit einem externen Spiegel (20) einen Laserresonator bildet,
oder
der Halbleiterlaser zwei externe Spiegel (36,38) aufweist, die einen Vertikalresonator bilden,
**dadurch gekennzeichnet, daß**
innerhalb des Laserresonators (10,20) bzw. des Vertikalresonators und in thermischem Kontakt mit der aktiven Schichtenfolge (14,34) eine für die emittierte Strahlung transparente Wärmesenke (12,32,32') angeordnet ist, die aus einem Material gebildet ist, das eine höhere Wärmeleitfähigkeit als die Materialien der aktiven Schichtenfolge (14, 34) aufweist.

2. Vertikal emittierender Halbleiterlaser nach Anspruch 1, bei dem die Wärmesenke (12) aus gut wärmeleitenden, im Roten und/oder Nahen Infrarot transparenten Materialien, bevorzugt aus SiC, BN oder Diamant gebildet ist.

3. Vertikal emittierender Halbleiterlaser nach Anspruch 1 oder 2, bei dem die Wärmesenke (12) durch eine Schicht einer Dicke von mindestens dem 0,2-fachen des Durchmessers der aktiven Zone gebildet.

4. Vertikal emittierender Halbleiterlaser nach einem der vorigen Ansprüche, bei dem die Wärmesenke (12) zwischen der aktiven Schichtenfolge (14) und der Reflektorschicht (10) angeordnet ist.

5. Vertikal emittierender Halbleiterlaser nach Anspruch 4, bei dem die Wärmesenke (12) in direktem Kontakt mit der aktiven Schichtenfolge (14) steht.

6. Vertikal emittierender Halbleiterlaser nach Anspruch 4, bei dem zwischen der Wärmesenke (12) und der aktiven Schichtenfolge (14) ein teilreflektierender Braggreflektor (16) angeordnet ist.

7. Vertikal emittierender Halbleiterlaser nach einem der Ansprüche 4 bis 6, bei dem die Reflektorschicht (10) durch einen verteilten Braggreflektor (42,44) gebildet ist.

8. Vertikal emittierender Halbleiterlaser nach Anspruch 6, bei dem die Reflektorschicht (10) durch eine Metallschicht gebildet ist.

9. Vertikal emittierender Halbleiterlaser nach einem der Ansprüche 3 bis 8, bei dem die Wärmesenke (12) oder eine weitere Wärmesenke (12', 12 ") auf der der Reflektorschicht (10) abgewandten Seite der aktiven Schichtenfolge (14) angeordnet ist.

10. Vertikal emittierender Halbleiterlaser nach einem der vorigen Ansprüche, bei dem die strahlungsemittierende aktive Schichtenfolge (14,34) aus einem auf GaAs oder InP basierenden Halbleitermaterial, insbesondere InGaAs, AlGaAs, InGaAlAs, InGaP, InGaAsP, InGaAlP, InAlP oder einer Abfolge von Schichten aus einem oder mehreren diesen Materialien besteht.

11. Optisch gepumpter vertikal emittierender Halbleiterlaser nach einem der Ansprüche 1 bis 5 und 10, bei dem die Pumpquelle (150) oder eine Mehrzahl von Pumpquellen neben dem optisch gepumpten vertikal emittierenden Halbleiterlaser (140) angeordnet und zusammen mit diesem auf einem gemeinsamen Substrat (100) monolithisch integriert ist.

12. Vertikal emittierender Halbleiterlaser nach Anspruch 11, bei dem die Pumpquelle (140) oder die Mehrzahl von Pumpquellen mindestens eine kantenemittierende Laserstruktur aufweist.

13. Vertikal emittierender Halbleiterlaser nach Anspruch 12, bei dem die kantenemittierende Laserstruktur oder die Mehrzahl von kantenemittierenden Laserstrukturen mittels Epitaxie vor oder nach dem epitaktischen Herstellen der Struktur (100) des optisch gepumpten vertikal emittierenden Halbleiterlasers (140) auf das gemeinsame Substrat (100) aufgewachsen wird.

## Claims

1. Optically pumped vertically emitting semiconductor laser having a radiation-emitting active layer sequence (14, 34), wherein either the semiconductor laser has a highly reflective reflector layer (10), on which the radiation-emitting active layer sequence (14) is arranged, and the reflector layer (10) during operation together with an external mirror (20) forms a laser resonator,

   or the semiconductor laser has two external mirrors (36, 38), which form a vertical resonator, **characterized in that**

   a heat sink (12, 32, 32') transparent to the emitted radiation is arranged within the laser resonator (10, 20) or the vertical resonator and in thermal contact with the active layer sequence (14, 34), said heat sink being formed from a material having a higher thermal conductivity than the materials of the active layer sequence (14, 34).

2. Vertically emitting semiconductor laser according to Claim 1, in which the heat sink (12) is formed from readily thermally conductive materials which are transparent in the red and/or near infrared, preferably from SiC, BN or diamond.

3. Vertically emitting semiconductor laser according to Claim 1 or 2, in which the heat sink (12) is formed by a layer having a thickness of at least 0.2 times the diameter of the active zone.

4. Vertically emitting semiconductor laser according to one of the preceding claims, in which the heat sink (12) is arranged between the active layer sequence (14) and the reflector layer (10).

5. Vertically emitting semiconductor laser according to Claim 4, in which the heat sink (12) is in direct contact with the active layer sequence (14).

6. Vertically emitting semiconductor laser according to Claim 4, in which a partly reflective Bragg reflector (16) is arranged between the heat sink (12) and the active layer sequence (14).

7. Vertically emitting semiconductor laser according to one of Claims 4 to 6, in which the reflector layer (10) is formed by a distributed Bragg reflector (42, 44).

8. Vertically emitting semiconductor laser according to Claim 6, in which the reflector layer (10) is formed by a metal layer.

9. Vertically emitting semiconductor laser according to one of Claims 3 to 8, in which the heat sink (12) or a further heat sink (12', 12") is arranged on that side of the active layer sequence (14) which is remote from the reflector layer (10).

10. Vertically emitting semiconductor laser according to one of the preceding claims, in which the radiation-emitting active layer sequence (14; 34) comprises a GaAs- or InP-based semiconductor material, in particular InGaAs, AlGaAs, InGaAlAs, InGaP, InGaAsP, InGaAlP, InAlP or a sequence of layers made of one or more of these materials.

11. Optically pumped vertically emitting semiconductor laser according to one of Claims 1 to 5 and 10, in which the pump source (150) or a plurality of pump sources is or are arranged beside the optically pumped vertically emitting semiconductor laser (140) and is or are monolithically integrated together with the latter on a common substrate (100).

12. Vertically emitting semiconductor laser according to Claim 11, in which the pump source (140) or the plurality of pump sources has or have at least one edge emitting laser structure.

13. Vertically emitting semiconductor laser according to Claim 12, in which the edge emitting laser structure or a plurality of edge emitting laser structures is or are grown by means of epitaxy before or after the epitaxial fabrication of the structure (100) of the optically pumped vertically emitting semiconductor laser (140) on the common substrate (100).

## Revendications

1. Laser semiconducteur à émission verticale à pompage optique, comprenant une série de couches actives (14, 34) émettrices de rayonnement, selon lequel

   soit

   le laser semiconducteur présente une couche de réflexion (10) fortement réfléchissante sur laquelle est disposée la série de couches actives (14) émettrices de rayonnement et la couche de réflexion (10), conjointement avec un miroir externe (20), forme en fonctionnement un résonateur laser,

   soit

   le laser semiconducteur présente deux miroirs externes (36, 38) qui forment un résonateur vertical, **caractérisé en ce qu'**à l'intérieur du résonateur laser (10, 20) ou du résonateur vertical, et en contact thermique avec la série de couches actives (14, 34), est disposé un dissipateur thermique (12, 32, 32') transparent pour le rayonnement émis, lequel est constitué d'un matériau qui présente une conductivité thermique supérieure à celle des matériaux de la série de couches actives (14, 34).

2. Laser semiconducteur à émission verticale selon la revendication 1, dans lequel le dissipateur thermique (12) est constitué de matériaux à bonne conduction thermique, transparents dans le rouge et/ou le proche infrarouge, de préférence de SiC, de BN ou de diamant.

**3.** Laser semiconducteur à émission verticale selon la revendication 1 ou 2, dans lequel le dissipateur thermique (12) est formé par une couche d'une épaisseur égale à au moins 0,2 fois le diamètre de la zone active.

**4.** Laser semiconducteur à émission verticale selon l'une des revendications précédentes, dans lequel le dissipateur thermique (12) est disposé entre la série de couches actives (14) et la couche de réflexion (10).

**5.** Laser semiconducteur à émission verticale selon la revendication 4, dans lequel le dissipateur thermique (12) se trouve en contact direct avec la série de couches actives (14).

**6.** Laser semiconducteur à émission verticale selon la revendication 4, dans lequel un réflecteur de Bragg (16) partiellement réfléchissant est disposé entre le dissipateur thermique (12) et la série de couches actives (14).

**7.** Laser semiconducteur à émission verticale selon l'une des revendications 4 à 6, dans lequel la couche de réflexion (10) est formée par un réflecteur de Bragg (42, 44) divisé.

**8.** Laser semiconducteur à émission verticale selon la revendication 6, dans lequel la couche de réflexion (10) est formée par une couche métallique.

**9.** Laser semiconducteur à émission verticale selon l'une des revendications 3 à 8, dans lequel le dissipateur thermique (12) ou un autre dissipateur thermique (12', 12 ") est disposé sur le côté de la série de couches actives (14) à l'opposé de la couche de réflexion (10).

**10.** Laser semiconducteur à émission verticale selon l'une des revendications précédentes, dans lequel la série de couches actives (14) émettrices de rayonnement se compose d'un matériau semiconducteur à base de GaAs ou d'InP, notamment de l'InGaAs, de l'AlGaAs, de l'InGaAlAs, de l'InGaP, de l'InGaAsP, de l'InGaAlP, de l'InAlP ou d'une séquence de couches en un ou plusieurs de ces matériaux.

**11.** Laser semiconducteur à émission verticale et à pompage optique selon l'une des revendications 1 à 5 et 10, dans lequel la source de pompage (150) ou une pluralité de sources de pompage est disposée à côté du laser semiconducteur à émission verticale et à pompage optique (140) et est intégrée conjointement avec celui-ci de manière monolithique sur un substrat (100) commun.

**12.** Laser semiconducteur à émission verticale selon la revendication 11, dans lequel la source de pompage (140) ou la pluralité de sources de pompage présente au moins une structure laser à émission par la tranche.

**13.** Laser semiconducteur à émission verticale selon la revendication 12, dans lequel la structure laser à émission par la tranche ou la pluralité de structures laser à émission par la tranche est mise en croissance par épitaxie sur le substrat (100) commun avant ou après la fabrication épitactique de la structure (100) du laser semiconducteur à émission verticale et à pompage optique (140).

## FIG 1

## FIG 2

## FIG 3

FIG 4

12'  14  12

10

FIG 5

12"  14'  12'  14  12

10

FIG 6

32'  34  32

30

36

38

# FIG 7

FIG. 8

Braggspiegel ~170

Resonator
(λ2)

~130

~120

Wärmesenke und Halterung

~140

Wärmesenke und Halterung

Wärmesenke/-spreizer

~110

λ1    λ1
Kantenemitter →Disklaser← Kantenemitter

~150

~150

Braggspiegel

~160

Substrat

~100

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6285702 B1

- DE 10026734

**In der Beschreibung aufgeführte Nicht-Patentliteratur**

- **Ortsiefer et al.** Low-threshold index-guided 1.5μm long-wavelength vertical cavity surface emitting laser with high efficiency. *Appl. Phys. Lett.,* 17. April 2000, vol. 76 (16), 2179-2181

- **M. Kuznetsov et al.** Design and Characteristics of High-Power (>0.5 W CW) Diode-Pumped Vertical-External-Cavity Surface-Emitting Semiconductor Lasers with Circular TEM00 Beams. *IEEE J. Selected Topics Quantum Electron.,* 1999, vol. 5 (3), 561-573